# EUROPEAN PATENT APPLICATION

(11) **EP 4 779 626 A1**
(43) Date of publication of application: **22.07.2026**
(21) Application number: 25227744.7
(22) Date of filing: 30.12.2025
(51) Int. Cl.: G09G 3/3233, H10K 59/131

(54) **DISPLAY PANEL AND DISPLAY APPARATUS**

(30) Priority: 17.01.2025 CN 202510080952
(71) Applicant: Wuhan China Star Optoelectronics Technology Co., Ltd, Wuhan, Hubei 430079 (CN)
(72) Inventor: LIAO, Xinxi, Wuhan, Hubei 430079 (CN)
(74) Representative: Studio Torta S.p.A.

(57) **Abstract**

A display panel and a display apparatus are provided. In the display panel, a driving circuit layer is provided and includes a plurality of light-emitting control lines, a plurality of reset control lines, a plurality of light-emitting transfer lines, and a plurality of reset transfer lines. One light-emitting transfer line is connected to one light-emitting control line, and one reset transfer line is connected to one reset control line. At least one light-emitting transfer line is provided with a break, and/or, at least one reset transfer line is provided with a break. The above configuration can prevent the accumulation of static electricity, reduce the risk of electrostatic damage caused by tip discharge, and improve the yield of the display panel.

## Description

### TECHNICAL FIELD

The present application relates to the field of display technologies, and in particular, to a display panel and a display apparatus.

### BACKGROUND

Organic light-emitting diode (OLED) display devices are widely used due to their advantages such as self-emission, wide color gamut, low power consumption, and the ability to achieve flexible displays. OLED display devices use pixel driving circuits for operation. However, during the use of OLED display devices, it has been found that some signal lines have relatively high impedance, which may easily lead to significant signal delays. This, in turn, can cause insufficient pixel charging or overcharging problems, resulting in poor display quality. To reduce the impedance of signal lines, some signal lines are designed with a double-layer structure, forming two parts of the signal line through two film layers to reduce the impedance. However, in practical use, it has been discovered that due to the relatively thin edges of the signal lines, static electricity may accumulate on the signal lines. This may easily lead to tip discharge between the edges of the signal lines and the active layer, which in turn conducts the active layer and the signal lines. As a result, the transistor cannot be turned off, causing bright spots on the display panel and leading to display anomalies.

Therefore, the existing display devices face the technical problem of display anomalies caused by tip discharge between the edges of the signal lines and the active layer.

### SUMMARY

The present application is set out in the appended set of claims.

Embodiments of the present application provide a display panel and a display apparatus, which can address a technical problem of display anomalies caused by tip discharge between the edges of the signal lines and the active layer in existing display devices.

In order to achieve the above object, some embodiments of the present application provide a display panel, including:
a substrate; and
a driving circuit layer disposed on a side of the substrate, where the driving circuit layer includes a plurality of light-emitting control lines, a plurality of reset control lines, a plurality of light-emitting transfer lines, and a plurality of reset transfer lines, one of the plurality of light-emitting transfer lines is connected to one of the plurality of light-emitting control lines, and one of the plurality of reset transfer lines is connected to one of the plurality of reset control lines;
where at least one of the plurality of light-emitting transfer lines is provided with a break, and/or at least one of the plurality of reset transfer lines is provided with a break.

Some embodiments of the present application provide a display apparatus, which includes the above-mentioned display panel.

The embodiments of the present application provide the display panel and the display apparatus as described above. In the display panel, the driving circuit layer includes a plurality of light-emitting control lines, a plurality of reset control lines, a plurality of light-emitting transfer lines, and a plurality of reset transfer lines. One light-emitting transfer line is connected to one light-emitting control line, and one reset transfer line is connected to one reset control line. At least one light-emitting transfer line is provided with a break, and/or, at least one reset transfer line is provided with a break. The above configuration can reduce the impedance of the light-emitting control line and the reset control line, and disperse static electricity across a plurality of sections of the light-emitting transfer line; and/or disperse static electricity across a plurality of sections of the reset transfer line. This prevents the accumulation of static electricity, reduces the risk of electrostatic damage caused by tip discharge, and improves the yield of the display panel.

The other features and advantages of the present application will be described in detail in the following detailed description of the embodiments.

### BRIEF DESCRIPTION OF THE DRAWINGS

In order to explain the technical solutions in the embodiments of the present application more clearly, the drawings required in the description of the embodiments will be briefly introduced below. Apparently, the drawings in the following description are merely some embodiments of the present application. For those skilled in the art, other drawings can be obtained from these drawings without any creative effort.

In order to fully understand the present application and beneficial effects thereof, the description will be given below in conjunction with the drawings, and the same reference numerals in the description below represent the same parts in the drawings.
FIG.1 is a schematic cross-sectional view of a comparative display device according to some embodiments of the present application.
FIG. 2 is a schematic plan view of a display panel according to some embodiments of the present application.
FIG. 3 is a first schematic cross-sectional view of the display panel according to some embodiments of the present application.
FIG. 4 is a second schematic cross-sectional view of the display panel according to some embodiments of the present application.
FIG. 5 is a circuit diagram of a pixel driving circuit in the display panel according to some embodiments of the present application.
FIG. 6 is a stack diagram of film layers in a pixel unit of the display panel according to some embodiments of the present application.
FIG. 7 is a schematic plan view of an active layer of the display panel in FIG. 6.
FIG. 8 is a schematic plan view of a first gate layer of the display panel in FIG. 6.
FIG. 9 is a schematic plan view of a second gate layer of the display panel in FIG. 6.
FIG. 10 is a schematic plan view of a first source-drain layer of the display panel in FIG. 6.
FIG. 11 is a schematic plan view of a second source-drain layer of the display panel in FIG. 6.
FIG. 12 is a schematic plan view of a pixel electrode layer of the display panel in FIG. 6.
FIG. 13 is a stack diagram of the active layer and the first gate layer of the display panel in FIG. 6.
FIG. 14 is a stack diagram of the active layer, the first gate layer, and the second gate layer of the display panel in FIG. 6.
FIG. 15 is a stack diagram of the active layer, the first gate layer, the second gate layer, and the first source-drain layer of the display panel in FIG. 6.
FIG. 16 is a stack diagram of the active layer, the first gate layer, the second gate layer, the first source-drain layer, and the second source-drain layer of the display panel in FIG. 6.
FIG. 17 is a schematic cross-sectional view taken along line A1-A2 of the display panel in FIG. 6.

### DETAILED DESCRIPTION

The technical solutions in the embodiments of the present application will be clearly and completely described with reference to the drawings of the present application. Apparently, the described embodiments are only some of the embodiments of the present application, rather than all of the embodiments. According to the embodiments of the present application, all other embodiments obtained by those skilled in the art without any creative effort shall fall within the protection scope of the present application.

To illustrate the principles behind the technical problem addressed by the embodiments of the present application, a comparative display device is provided. It can be understood that the contents disclosed in this comparative display device should not be considered as the prior art of the embodiments of the present application. Specifically, the comparative display device includes a plurality of sub-pixel units, each of which includes a pixel driving circuit and a light-emitting device. The pixel driving circuit includes a light-emitting control trace and a reset control trace. The light-emitting control trace is connected to a light-emitting control transistor, and the reset control trace is connected to a reset transistor. To reduce the impedance of the light-emitting control trace and the impedance of the reset control trace, the light-emitting control trace and the reset control trace are each designed with a double-layer configuration.

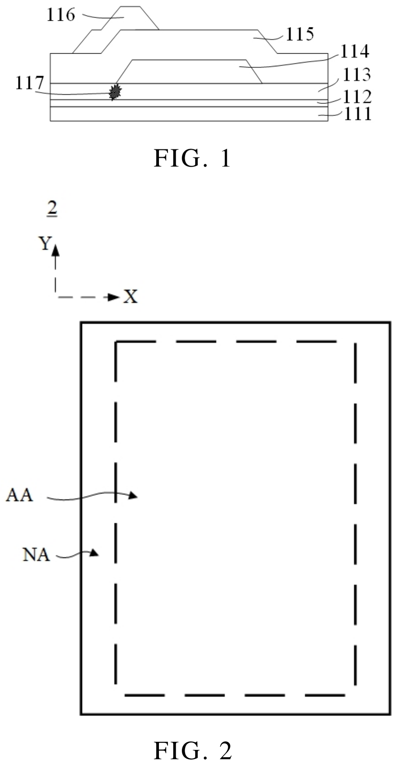

As shown in FIG. 1, the comparative display device includes a substrate 111, a semiconductor film layer 112, a first insulating film layer 113, a first gate film layer 114, a second insulating film layer 115, and a first source-drain film layer 116. The light-emitting control trace includes a first light-emitting control trace disposed in the first gate film layer 114 and a second light-emitting control trace disposed in the first source-drain film layer 116. The reset control trace includes a first reset control trace disposed in the first gate film layer 114 and a second reset control trace disposed in the first source-drain film layer 116. Since the light-emitting control trace is a double-layer trace, and both the first light-emitting control trace and the second light-emitting control trace are long traces, it is easy for static electricity to accumulate on the light-emitting control trace. Additionally, the second light-emitting control trace and the first light-emitting control trace are arranged in a staggered configuration, resulting in a relatively large capacitance between the second light-emitting control trace and the semiconductor film layer 112, which further increases the capacitance between the light-emitting control trace and the semiconductor film layer 112. Furthermore, the first light-emitting control trace is relatively close to the semiconductor film layer 112, and the edge of the first light-emitting control trace is relatively thin. This makes it prone to occurring tip discharge between the first light-emitting control trace and the semiconductor film layer 112, leading to electrostatic damage. Consequently, this causes electrical conduction between the light-emitting control trace and the active pattern of the light-emitting transistor. Since the light-emitting control trace controls the light-emitting transistor, this may cause the light-emitting transistor to remain continuously on, keeping the sub-pixel unit constantly lit and resulting in bright spots, which lead to poor display quality. Similarly, the first reset control trace and the second reset control trace are long lines, making it easy for static electricity to accumulate on the reset control trace. Additionally, the first reset control trace is relatively close to the semiconductor film layer 112, and the edge of the first reset control trace is relatively thin. This makes it prone to occurring tip discharge between the first reset control trace and the semiconductor film layer 112, leading to electrostatic damage. Consequently, this causes electrical conduction between the reset control trace and the active pattern of the reset transistor. Since the reset control trace controls the reset transistor, this may cause the reset transistor to remain continuously on, leading to display anomalies of the sub-pixel unit. Therefore, the existing display devices face the technical problem of display anomalies caused by tip discharge between the edges of the signal lines and the active layer.

The embodiments of the present application provide a display panel and a display apparatus to address the above-mentioned technical problem.

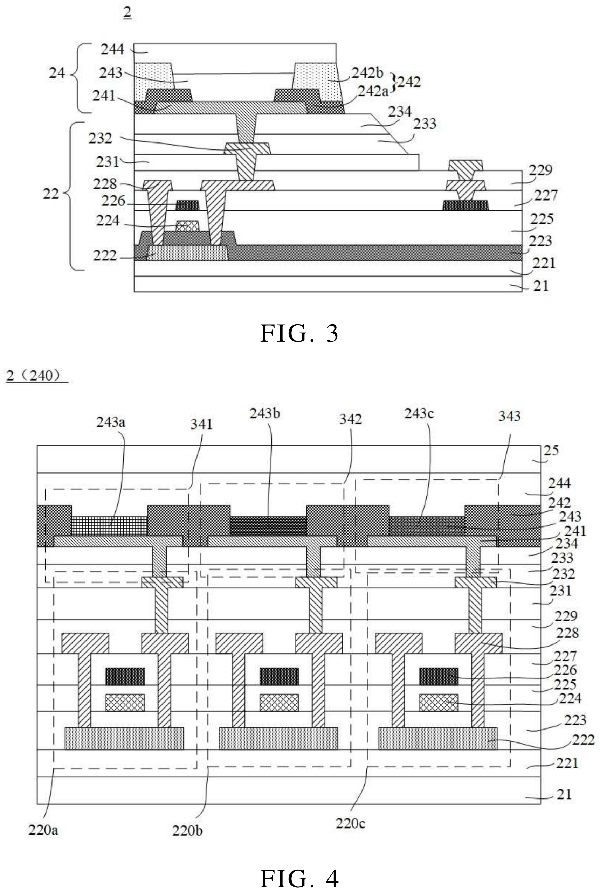

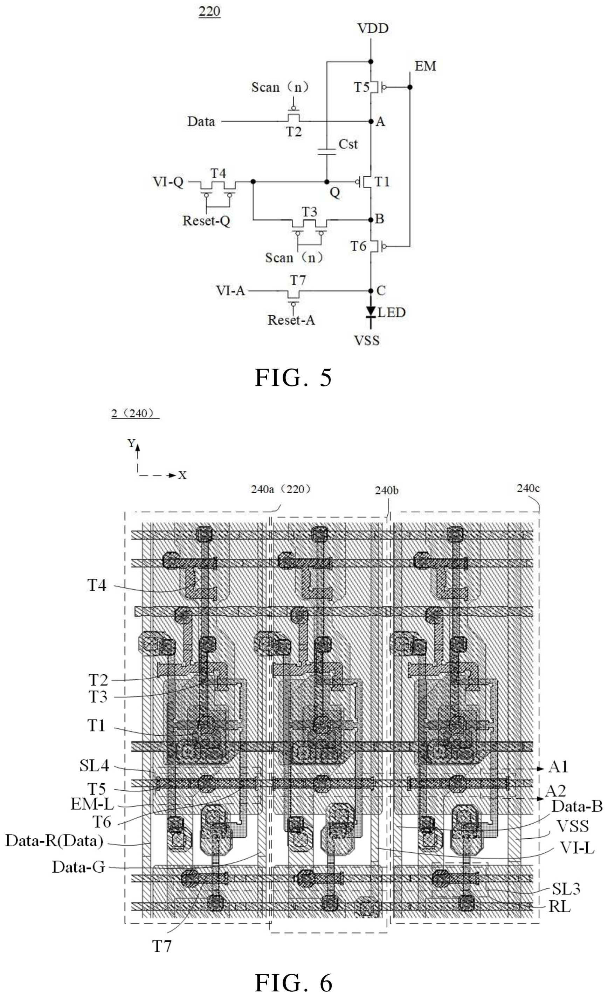

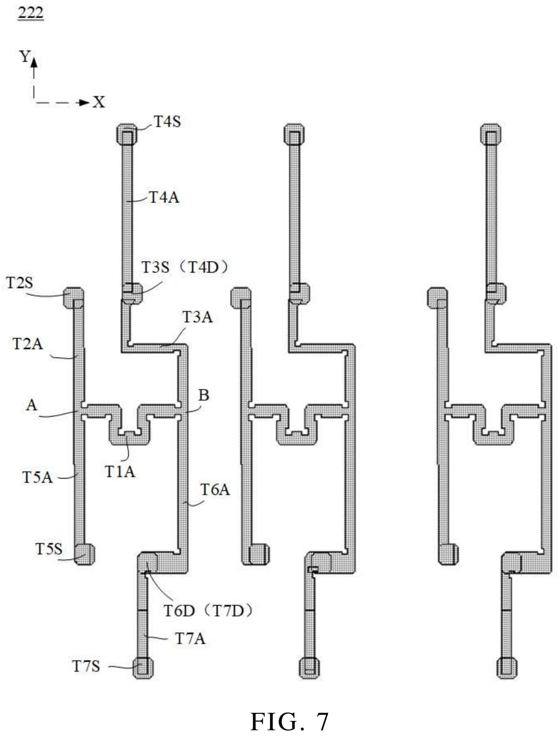

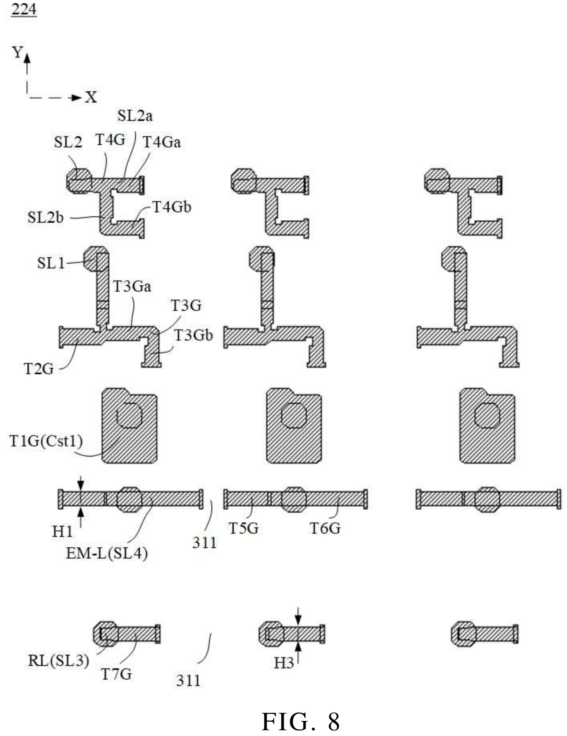

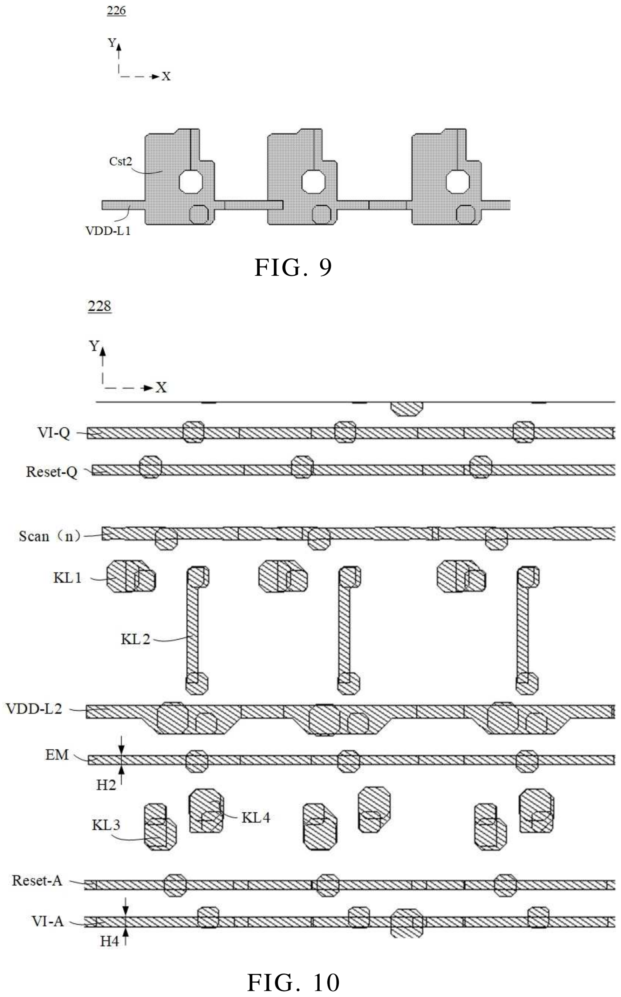

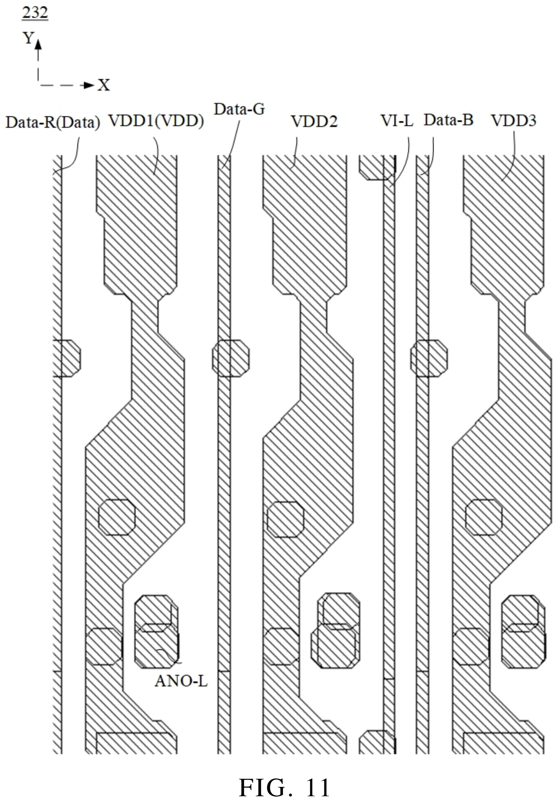

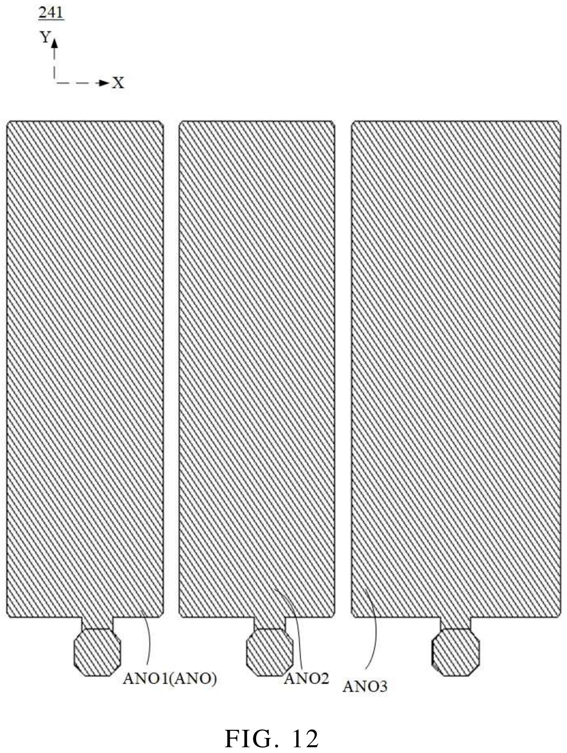

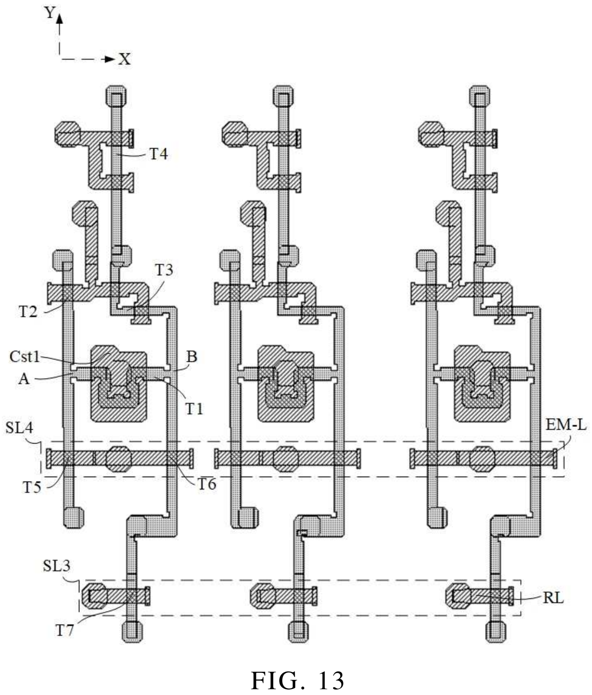

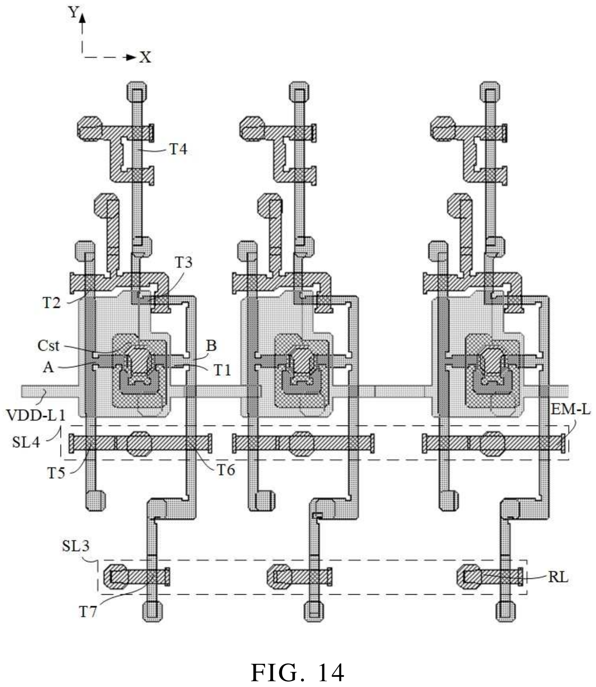

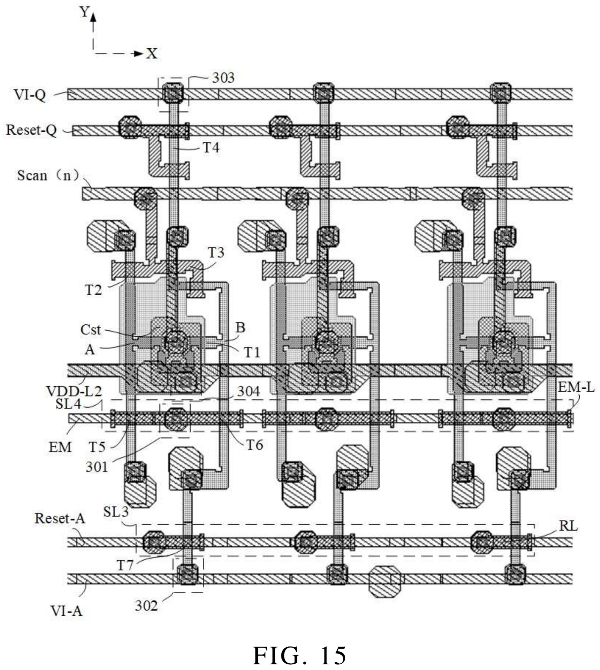

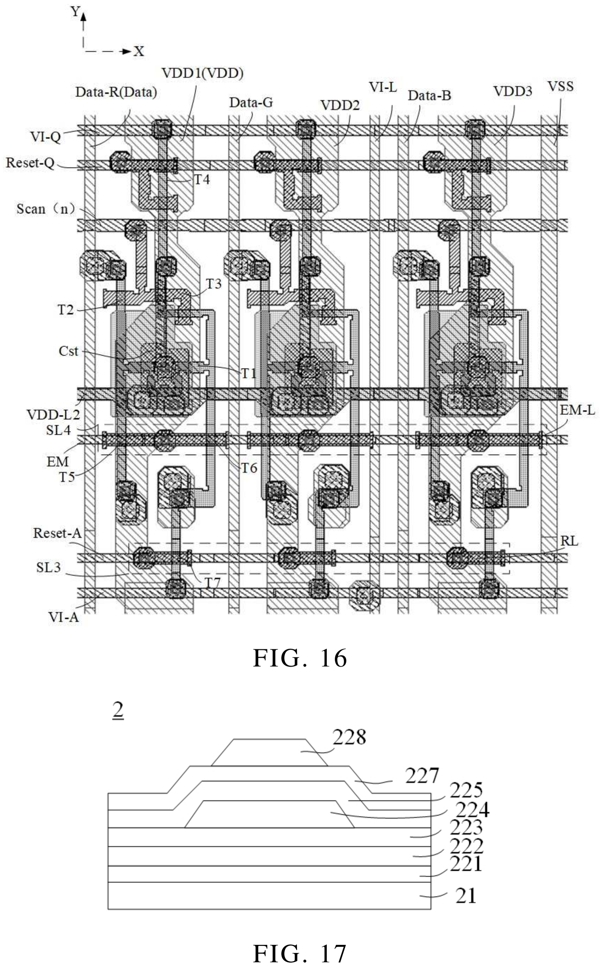

FIG. 2 is a schematic plan view of a display panel according to some embodiments of the present application. FIG. 3 is a first schematic cross-sectional view of the display panel according to some embodiments of the present application. FIG. 4 is a second schematic cross-sectional view of the display panel according to some embodiments of the present application. FIG. 5 is a circuit diagram of a pixel driving circuit in the display panel according to some embodiments of the present application. FIG. 6 is a stack diagram of film layers in a pixel unit of the display panel according to some embodiments of the present application. FIG. 7 is a schematic plan view of an active layer of the display panel in FIG. 6. FIG. 8 is a schematic plan view of a first gate layer of the display panel in FIG. 6. FIG. 9 is a schematic plan view of a second gate layer of the display panel in FIG. 6. FIG. 10 is a schematic plan view of a first source-drain layer of the display panel in FIG. 6. FIG. 11 is a schematic plan view of a second source-drain layer of the display panel in FIG. 6. FIG. 12 is a schematic plan view of a pixel electrode layer of the display panel in FIG. 6. FIG. 13 is a stack diagram of the active layer and the first gate layer of the display panel in FIG. 6. FIG. 14 is a stack diagram of the active layer, the first gate layer, and the second gate layer of the display panel in FIG. 6. FIG. 15 is a stack diagram of the active layer, the first gate layer, the second gate layer, and the first source-drain layer of the display panel in FIG. 6. FIG. 16 is a stack diagram of the active layer, the first gate layer, the second gate layer, the first source-drain layer, and the second source-drain layer of the display panel in FIG. 6. FIG. 17 is a schematic cross-sectional view taken along line A1-A2 of the display panel in FIG. 6.

As shown in FIGs. 2 to 17, some embodiments of the present application provide a display panel 2, which includes a substrate 21 and a driving circuit layer 22. The driving circuit layer is disposed on a side of the substrate. The driving circuit layer 22 includes a plurality of light-emitting control lines EM, a plurality of reset control lines Reset-A, a plurality of light-emitting transfer lines SL4, and a plurality of reset transfer lines SL3. One of the light-emitting transfer lines SL4 is connected to one of the light-emitting control lines EM. One of the reset transfer lines SL3 is connected to one of the reset control lines Reset-A.

At least one of the light-emitting transfer lines SL4 is provided with a break 311, and/or at least one of the reset transfer lines SL3 is provided with a break.

The embodiments of the present application provide the display panel as described above. In this display panel, the driving circuit layer includes the plurality of light-emitting control lines, the plurality of reset control lines, the plurality of light-emitting transfer lines, and the plurality of reset transfer lines. One of the light-emitting transfer lines is connected to one of the light-emitting control lines, and one of the reset transfer lines is connected to one of the reset control lines. At least one of the light-emitting transfer lines is provided with a break, and/or at least one of the reset transfer lines is provided with a break. The above configuration can reduce the impedance of the light-emitting control line and the reset control line, and disperse static electricity across a plurality of sections of the light-emitting transfer line; and/or disperse static electricity across a plurality of sections of the reset transfer line. This prevents the accumulation of static electricity, reduces the risk of electrostatic damage caused by tip discharge, and improves the yield of the display panel.

Specifically, the light-emitting control line EM and the light-emitting transfer line SL4 are arranged in different layers. The reset transfer line SL3 and the reset control line Reset-A are arranged in different layers.

In some embodiments, as shown in FIGs. 2 to 17, the display panel 2 includes a plurality of pixel units 240. Each pixel unit 240 includes a plurality of sub-pixel units (e.g., a first sub-pixel unit 240a, a second sub-pixel unit 240b, and a third sub-pixel unit 240c). The light-emitting transfer line SL4 includes a plurality of light-emitting connection lines EM-L, with a break 311 between two adjacent light-emitting connection lines EM-L. Each light-emitting connection line EM-L is disposed corresponding to one of the sub-pixel units. By configuring each light-emitting connection line to correspond to a sub-pixel unit, each light-emitting connection line can drive the respective transistors, ensuring the normal operation of each sub-pixel unit. Additionally, by dividing the light-emitting transfer line into a plurality of light-emitting connection lines, static electricity is further dispersed, preventing its accumulation, reducing the risk of electrostatic damage caused by tip discharge, and improving the yield of the display panel.

In some embodiments, as shown in FIGs. 2 to 17, the display panel 2 includes a plurality of pixel units 240. Each pixel unit 240 includes a plurality of sub-pixel units (e.g., a first sub-pixel unit 240a, a second sub-pixel unit 240b, and a third sub-pixel unit 240c). The reset transfer line SL4 includes a plurality of reset connection lines RL, with a break between two adjacent reset connection lines RL. Each reset connection line RL is disposed corresponding to one of the sub-pixel units. By configuring each reset connection line to correspond to a sub-pixel unit, each reset connection line can drive the respective transistors, ensuring the normal operation of each sub-pixel unit. Additionally, by dividing the reset transfer line into a plurality of reset connection lines, static electricity is further dispersed, preventing its accumulation, reducing the risk of electrostatic damage caused by tip discharge, and improving the yield of the display panel.

The above embodiments are explained using the example where the break is disposed between two sub-pixel units, but the embodiments of the present application are not limited to this. The break can be set within a sub-pixel unit, as long as the break avoids the active pattern of the transistor. In other words, the orthographic projection of the break on the substrate does not overlap with the orthographic projection of the active pattern of the transistor on the substrate.

In some embodiments, as shown in FIGs. 2 to 17, the display panel 2 includes a plurality of pixel units 240. Each pixel unit 240 includes a plurality of sub-pixel units (e.g., a first sub-pixel unit 240a, a second sub-pixel unit 240b, and a third sub-pixel unit 240c). The light-emitting transfer line SL4 includes a plurality of light-emitting connection lines EM-L, with a break 311 between two adjacent light-emitting connection lines EM-L. Each light-emitting connection line EM-L is disposed corresponding to one of the sub-pixel units. The reset transfer line SL4 includes a plurality of reset connection lines RL, with a break between two adjacent reset connection lines RL. Each reset connection line RL is disposed corresponding to one of the sub-pixel units. By configuring each light-emitting connection line to correspond to one sub-pixel unit and each reset connection line to correspond to one sub-pixel unit, each light-emitting connection line can drive a corresponding transistor, and each reset connection line can also drive a corresponding transistor, ensuring the normal operation of each sub-pixel unit. Additionally, by dividing the light-emitting transfer line into a plurality of light-emitting connection lines and the reset transfer line into a plurality of reset connection lines, static electricity is further dispersed, preventing its accumulation, reducing the risk of electrostatic damage caused by tip discharge, and thus improving the yield of the display panel. Specifically, each light-emitting connection line may be connected to a light-emitting control line, and each reset connection line may be connected to a reset control line.

In some embodiments, as shown in FIGs. 2 to 17, the driving circuit layer 22 includes a first gate layer 224 and a first source-drain layer 228. The first gate layer 224 is disposed between the substrate 21 and the first source-drain layer 228. The light-emitting connection lines EM-L and the reset connection lines RL are included in the first gate layer 224. The light-emitting control lines EM and the reset control lines Reset-A are included in the first source-drain layer 228. By configuring the light-emitting connection lines and the reset connection lines in the first gate layer, and the light-emitting control lines and the reset control lines in the first source-drain layer, with each light-emitting connection line connected to a light-emitting control line and each reset connection line connected to a reset control line, both the impedance of the light-emitting control lines and the impedance of the reset control lines can be reduced. Additionally, by setting the plurality of light-emitting connection lines connected to the same light-emitting control line in a disconnected configuration, and the plurality of reset connection lines connected to the same reset control line in a disconnected configuration, static electricity accumulation can be avoided. This reduces the risk of electrostatic damage caused by tip discharge and improves the yield of the display panel.

As shown in FIGs. 2 to 17, some embodiments of the present application provide a display panel 2, which includes a plurality of pixel units 240. Each pixel unit 240 includes a plurality of sub-pixel units (e.g., a first sub-pixel unit 240a, a second sub-pixel unit 240b, and a third sub-pixel unit 240c). The display panel 2 includes a substrate 21 and a driving circuit layer 22. The driving circuit layer 22 is disposed on a side of the substrate 21. The driving circuit layer 22 includes a first gate layer 224 and a first source-drain layer 228. The first gate layer 224 is disposed between the substrate 21 and the first source-drain layer 228. The plurality of light-emitting connection lines EM-L and the plurality of reset connection lines RL are included in the first gate layer 224. The light-emitting control line EM and the reset control line Reset-A are included in the first source-drain layer 228. The light-emitting connection lines EM-L are connected to the light-emitting control line EM. The reset connection lines RL are connected to the reset control line Reset-A.

Within two adjacent sub-pixel units (e.g., the first sub-pixel unit 240a and the second sub-pixel unit 240b), two adjacent light-emitting connection lines EM-L are disconnected, and/or two adjacent reset connection lines RL are disconnected.

The embodiments of the present application provides the display panel as described above. In this display panel, the first gate layer 224 includes the plurality of light-emitting connection lines EM-L and the plurality of reset connection lines RL, and the first source-drain layer 228 includes the light-emitting control line EM and the reset control line Reset-A. The light-emitting connection lines EM-L are connected to the light-emitting control line EM, and the reset connection lines RL are connected to the reset control line Reset-A. Within two adjacent sub-pixel units, two adjacent light-emitting connection lines EM-L are set in a disconnected configuration, and/or two adjacent reset connection lines RL are set in a disconnected configuration, so that the impedance of the light-emitting control line and the impedance of the reset control line can be reduced. Additionally, static electricity is dispersed across the plurality of light-emitting connection lines and/or the plurality of reset connection lines, preventing static electricity accumulation. This reduces the risk of electrostatic damage caused by tip discharge and improves the yield of the display panel.

Specifically, there are slopes at the edges of the light-emitting connection line and the reset connection line.

Specifically, in the first direction, within two adjacent sub-pixel units, two adjacent light-emitting connection lines are arranged in a disconnected configuration, and/or two adjacent reset connection lines are arranged in a disconnected configuration.

Specifically, it can be understood that in the pixel driving circuit, each transistor has a gate, a first electrode, and a second electrode. However, during the actual manufacturing process, to reduce the space occupied by the transistors, some transistor electrodes are not set separately. Instead, the electrodes and signal lines of each transistor are directly connected. For example, in the pixel driving circuit, the first electrode of a driving transistor T1 is connected to the second electrode of a switching transistor T2 at a first node A. When fabricating the driving transistor and the switching transistor, there is no need to separately set the first electrode of the driving transistor and the second electrode of the switching transistor. The active pattern of the driving transistor is directly connected to the active pattern of the switching transistor. The connection point between the active pattern of the driving transistor and the active pattern of the switching transistor can be considered as the first node A, thereby reducing the number of electrodes and minimizing the space occupied by the transistors. In another example, the first electrode of the compensation transistor is connected to the second electrode of the initialization transistor. However, in the actual design, there is no need to separately set the first electrode of the compensation transistor and the second electrode of the initialization transistor. Instead, the active pattern of the compensation transistor can be directly connected to the active pattern of the initialization transistor. The connection point between the active pattern of the compensation transistor and the active pattern of the initialization transistor can be considered as the point connected to the node Q, or regarded as the node Q itself. This reduces the number of electrodes and minimizes the space occupied by the transistors. Similarly, other structures not labeled in the film layer diagram also adopt the above design, as explained previously, and will not be elaborated further in the following embodiments.

Specifically, during the actual manufacturing process, to reduce the space occupied by transistors, another approach is to share electrodes among a plurality of transistors or to share the same structure between the electrodes and signal lines of the transistors. For example, the gate of the driving transistor can be connected to an electrode plate of the storage capacitor, eliminating the need to separately set the gate of the driving transistor and one electrode plate of the storage capacitor. A single structure can serve as both the gate of the driving transistor and an electrode plate of the storage capacitor. Similarly, for other instances where the same structure is used as electrodes and/or signal lines for a plurality of transistors, the previous explanation applies, and further elaboration will not be provided in the following embodiments.

Specifically, the display panel includes a plurality of repeating units. A repeating unit may include a single pixel unit, such as the pixel unit shown in FIG. 6 according to some embodiments of the present application, or a pixel unit where the reset connection line is electrically connected to the first electrode of the initialization transistor. A repeating unit may also include two pixel units, with the difference between them being that in one pixel unit, the reset connection line is electrically connected to the first electrode of the initialization transistor, and the first electrode of the initialization transistor is connected to the initialization signal line, thereby reducing the voltage drop across the initialization signal line. In the other pixel unit, the reset connection line is electrically connected to the reset signal line, thereby reducing the voltage drop across the reset signal line. For other parts, the two pixel units can be identical. The following embodiments will be explained using a repeating unit that includes a single pixel unit as an example.

Specifically, the display panel may include a plurality of pixel units 240, each of which may include a plurality of sub-pixel units. The plurality of sub-pixel units may include a first sub-pixel unit 240a, a second sub-pixel unit 240b, and a third sub-pixel unit 240c. Each of the first sub-pixel unit 240a, the second sub-pixel unit 240b, and the third sub-pixel unit 240c includes a pixel driving circuit 220 and a light-emitting device LED. The designs of the light-emitting devices in the first sub-pixel unit 240a, the second sub-pixel unit 240b, and the third sub-pixel unit 240c may vary. Specifically, the light-emitting devices of the first sub-pixel unit 240a, the second sub-pixel unit 240b, and the third sub-pixel unit 240c may have different emission colors, and/or different areas, and/or different thicknesses.

For example, the emission colors of the first sub-pixel unit, the second sub-pixel unit, and the third sub-pixel unit may be red, green, and blue, respectively. However, the embodiments of the present application are not limited to this configuration. For example, the emission colors of the first sub-pixel unit, the second sub-pixel unit, and the third sub-pixel unit may be red, blue, and green, respectively; alternatively, the emission colors of the first sub-pixel unit, the second sub-pixel unit, and the third sub-pixel unit may be blue, green, and red, respectively.

Specifically, in the embodiments of the present application, it should be noted that, except for the explicitly stated differences, the design of all pixel units can refer to the design provided in the embodiments of the present application. Similarly, the design of all pixel driving circuits can refer to the design of the pixel driving circuit in the embodiments of the present application. For example, if the difference between two pixel driving circuits is that the high-potential power line in one pixel driving circuit is different from that in the other, while all other aspects of the two pixel driving circuits are the same, then when describing the design of the pixel driving circuit, it can be considered that, except for the difference in the high-potential power line, all other designs of the two pixel driving circuits are the same. Similarly, the differences and similarities in the design of pixel units can be determined and will not be reiterated in the following embodiments.

Specifically, as shown in FIG. 2, the display panel 2 includes a display region AA and a non-display region NA. The pixel units are disposed in the display region AA.

Specifically, as shown in FIG. 3 and FIG. 4, the display panel 2 includes a substrate 21, a driving circuit layer 22, a light-emitting functional layer 24, and an encapsulation layer 25.

Specifically, the driving circuit layer 22 includes a buffer layer 221, an active layer 222, a first gate insulating layer 223, a first gate layer 224, a second gate insulating layer 225, a second gate layer 226, an interlayer insulating layer 227, a first source-drain layer 228, a passivation layer 229, a first planarization layer 231, a second source-drain layer 232, a second planarization layer 233, and a third planarization layer 234. The buffer layer 221 is disposed on a side of the substrate 21. The active layer 222 is disposed on a side of the buffer layer 221 that is away from the substrate 21. The first gate insulating layer 223 is disposed on a side of the active layer 222 that is away from the buffer layer 221. The first gate layer 224 is disposed on a side of the first gate insulating layer 223 that is away from the active layer 222. The second gate insulating layer 225 is disposed on a side of the first gate layer 224 that is away from the first gate insulating layer 223. The second gate layer 226 is disposed on a side of the second gate insulating layer 225 that is away from the first gate layer 224. The interlayer insulating layer 227 is disposed on a side of the second gate layer 226 that is away from the second gate insulating layer 225. The first source-drain layer 228 is disposed on a side of the interlayer insulating layer 227 that is away from the second gate layer 226. The passivation layer 229 is disposed on a side of the first source-drain layer 228 that is away from the interlayer insulating layer 227. The first planarization layer 231 is disposed on a side of the passivation layer 229 that is away from the first source-drain layer 228. The second source-drain layer 232 is disposed on a side of the first planarization layer 231 that is away from the passivation layer 229. The second planarization layer 233 is disposed on a side of the second source-drain layer 232 that is away from the first planarization layer 231. The third planarization layer 234 is disposed on a side of the second planarization layer 233 that is away from the second source-drain layer 232.

Specifically, the light-emitting functional layer 24 includes a pixel electrode layer 241, a pixel definition layer 242, a light-emitting material layer 243, and a common electrode layer 244. The pixel definition layer 242 is disposed on a side of the pixel electrode layer 241 that is away from the driving circuit layer 22. The light-emitting material layer 243 is disposed on a side of the pixel definition layer 242 that is away from the pixel electrode layer 241. The common electrode layer 244 is disposed on a side of the light-emitting material layer 243 that is away from the pixel definition layer 242.

Specifically, the pixel definition layer 242 may include a first pixel definition layer 242a and a second pixel definition layer 242b. However, the embodiments of the present application are not limited to this. For example, and the pixel definition layer may also be designed as a single layer.

Specifically, the encapsulation layer 25 includes a first inorganic layer, an organic layer, and a second inorganic layer.

Specifically, the light-emitting functional layer 24 includes a light-emitting device LED. The pixel electrode layer 241 of the light-emitting functional layer 24 includes an anode ANO of the light-emitting device LED.

Specifically, since the embodiments of the present application describe the display panel in terms of its circuits, film layer structure, and the design of each film layer, there may be instances where a particular structure belongs to more than one category. This is due to the different perspectives used for definition. For example, the pixel driving circuit belongs to the driving circuit layer, which is considered from the perspective of the film layer structure, as the pixel driving circuit is formed by the structures within the driving circuit layer. Additionally, the pixel unit includes the pixel driving circuit, which is considered from the design perspective of the pixel unit, as each pixel unit needs to be driven by a corresponding pixel driving circuit. It can be understood that the pixel driving circuit, which belongs to both the driving circuit layer and the pixel unit, is the same pixel driving circuit. Similarly, other similar definitions can refer to the explanations above and will not be reiterated in the following embodiments.

In some embodiments, within any two of the sub-pixel units, two adjacent light-emitting connection lines are arranged in a disconnected configuration. By having two adjacent light-emitting connection lines disconnected within any two sub-pixel units, static electricity can be dispersed across the plurality of light-emitting connection lines. This reduces the risk of tip discharge occurring between the light-emitting connection lines and the active layer, thereby improving the yield of the display panel.

Specifically, compared with the comparative display device where the first light-emitting control trace is a long trace, static electricity tends to accumulate on the first light-emitting control trace. Additionally, due to the presence of slopes at the edges of the first light-emitting control trace, where the thickness is relatively smaller, there is a higher likelihood of tip discharge occurring between the slopes of the first light-emitting control trace and the semiconductor film layer. In the embodiments of the present application, by arranging two adjacent light-emitting connection lines to be disconnected, static electricity can be dispersed and released across the plurality of light-emitting connection lines. This prevents the problem of electrostatic breakdown between the light-emitting connection lines and the active pattern due to static accumulation, thereby reducing the risk of tip discharge between the light-emitting connection lines and the active layer and improving the yield of the display panel.

In some embodiments, within any two of the sub-pixel units, two adjacent reset connection lines are arranged in a disconnected configuration. By having two adjacent reset connection lines disconnected within any two sub-pixel units, static electricity can be dispersed across the plurality of reset connection lines. This reduces the risk of tip discharge occurring between the reset connection lines and the active layer, thereby improving the yield of the display panel.

Specifically, compared with the comparative display device where the first reset control trace is a long trace, static electricity tends to accumulate on the first reset control trace. Additionally, due to the presence of slopes at the edges of the first reset control trace, where the thickness is relatively smaller, there is a higher likelihood of tip discharge occurring between the slopes of the first reset control trace and the semiconductor film layer. In the embodiments of the present application, by arranging two adjacent reset connection lines to be disconnected, static electricity can be dispersed and released across the plurality of reset connection lines. This prevents the problem of electrostatic breakdown between the reset connection lines and the active pattern due to static accumulation, thereby reducing the risk of tip discharge between the reset connection lines and the active layer and improving the yield of the display panel.

In some embodiments, as shown in FIGs. 6 to 15, within any two sub-pixel units, two adjacent light-emitting connection lines EM-L are arranged in a disconnected configuration, and two adjacent reset connection lines RL are also arranged in a disconnected configuration. By arranging two adjacent light-emitting connection lines in a disconnected configuration and two adjacent reset connection lines in a disconnected configuration within any two sub-pixel units, static electricity can be dispersed across the plurality of light-emitting connection lines and the plurality of reset connection lines. This reduces the risk of tip discharge occurring between the light-emitting connection lines and the active layer, as well as between the reset connection lines and the active layer, thereby improving the yield of the display panel.

Specifically, compared with the comparative display device where both the first light-emitting control trace and the first reset control trace are long traces, static electricity tends to accumulate on the first light-emitting control trace and the first reset control trace. Additionally, due to the presence of slopes at the edges of both the first light-emitting control trace and the first reset control trace, where the thicknesses are relatively smaller, there is a higher likelihood of tip discharge occurring between these slopes and the semiconductor film layer. In the embodiments of the present application, by arranging two adjacent light-emitting connection lines to be disconnected and two adjacent reset connection lines to be disconnected, static electricity can be dispersed and released across the plurality of light-emitting connection lines and the plurality of reset connection lines, respectively. This prevents the problem of electrostatic breakdown between the light-emitting connection lines and the active pattern, as well as between the reset connection lines and the active pattern, due to static electricity accumulation. Consequently, this reduces the risk of tip discharge occurring between the light-emitting connection lines and the active layer, as well as between the reset connection lines and the active layer, thereby improving the yield of the display panel.

In some embodiments, as shown in FIGs. 6 to 16, both the light-emitting control line EM and the light-emitting connection line EM-L extend along the first direction X. the orthographic projection of the light-emitting connection line EM-L on the substrate 21 is at least partially overlapped with the orthographic projection of the light-emitting control line EM on the substrate 21. The width H1 of the light-emitting connection line EM-L in the second direction Y is greater than or equal to the width H2 of the light-emitting control line EM in the second direction Y. Within the overlapping region between the light-emitting connection line EM-L and the light-emitting control line EM, the orthographic projection of the light-emitting control line EM on the substrate 21 is located within the orthographic projection of the light-emitting connection line EM-L on the substrate. The angle between the first direction X and the second direction Y is greater than 0 and less than or equal to 90 degrees. By ensuring that the orthographic projection of the light-emitting connection line EM-L on the substrate 21 overlaps with the orthographic projection of the light-emitting control line EM on the substrate 21, and that the width of the light-emitting connection line EM-L in the second direction Y is greater than or equal to the width of the light-emitting control line EM in the second direction Y, the orthographic projection of the light-emitting control line EM on the substrate is located within the orthographic projection of the light-emitting connection line EM-L on the substrate in the overlapping region between the light-emitting control line EM and the light-emitting connection line EM-L. This arrangement allows the light-emitting connection line EM-L to shield the light-emitting control line, preventing the formation of capacitance between the light-emitting control line EM-L and the active pattern. As a result, the capacitance between the light-emitting control line and the active pattern is reduced, which lowers the risk of tip discharge occurring between the light-emitting connection line and the active layer, thereby improving the yield of the display panel.

Specifically, compared with the comparative display device where the first light-emitting control trace and the second light-emitting control trace are arranged in a staggered configuration, each forming a coupling capacitance with the active pattern, this may lead to electrostatic damage caused by tip discharge between the first light-emitting control trace and the active pattern. In the above embodiments of the present application, the width of the light-emitting connection line in the second direction is greater than or equal to the width of the light-emitting control line in the second direction, and the orthographic projection of the light-emitting control line on the substrate is located within the orthographic projection of the light-emitting connection line on the substrate in the overlapping region between the light-emitting control line and the light-emitting connection line. This allows the light-emitting connection line to cover the light-emitting control line, thereby reducing or even eliminating the coupling capacitance between the light-emitting control line and the active pattern, thereby reducing the risk of tip discharge between the light-emitting connection line and the active pattern, and improving the yield of the display panel.

Specifically, within the region corresponding to the active pattern, the orthographic projection of the light-emitting control line on the substrate is located within the orthographic projection of the light-emitting connection line on the substrate.

In some embodiments, as shown in FIGs. 6 to 16, both the reset control line Reset-Q and the reset connection line RL extend along the first direction X. The orthographic projection of the reset connection line RL on the substrate 21 is at least partially overlapped with the orthographic projection of the reset control line Reset-Q on the substrate 21. The width H3 of the reset connection line RL in the second direction Y is greater than or equal to the width H4 of the reset control line Reset-Q in the second direction Y. In the overlapping region between the reset connection line RL and the reset control line Reset-Q, the orthographic projection of the reset control line Reset-Q on the substrate 21 is located within the orthographic projection of the reset connection line RL on the substrate 21. The angle between the first direction and the second direction is greater than 0 and less than or equal to 90 degrees. By ensuring that the orthographic projection of the reset connection line RL on the substrate 21 overlaps with the orthographic projection of the reset control line Reset-Q on the substrate 21, and that the width of the reset connection line RL in the second direction Y is greater than or equal to the width of the reset control line Reset-Q in the second direction, the orthographic projection of the reset control line Reset-Q on the substrate 21 is located within the orthographic projection of the reset connection line RL on the substrate 21 in the overlapping region between the reset control line Reset-Q and the reset connection line RL. This arrangement allows the reset connection line RL to shield the reset control line Reset-Q, preventing the formation of capacitance between the reset control line Reset-Q and the active pattern. As a result, the capacitance between the light-emitting control line and the active pattern is reduced, which lowers the risk of tip discharge occurring between the light-emitting connection line and the active layer, thereby improving the yield of the display panel.

Specifically, compared with the comparative display device where the first reset control trace and the second reset control trace are arranged in a staggered configuration, each forming a coupling capacitance with the active pattern, this may lead to electrostatic damage caused by tip discharge between the first reset control trace and the active pattern. In the embodiments of the present application, the width of the reset connection line in the second direction is greater than or equal to the width of the reset control line in the same direction, and the orthographic projection of the reset control line Reset-Q on the substrate 21 is located within the orthographic projection of the reset connection line RL on the substrate 21 in the overlapping region between the reset control line Reset-Q and the reset connection line R. This allows the reset connection line to cover the reset control line, thereby reducing or even eliminating the coupling capacitance between the reset control line and the active pattern. As a result, the risk of tip discharge between the reset connection line and the active pattern is lowered, improving the yield of the display panel.

Specifically, within the region corresponding to the active pattern, the orthographic projection of the reset control line on the substrate is located within the orthographic projection of the reset connection line on the substrate.

Specifically, as shown in FIG. 8 and FIG. 16, in some embodiments of the present application, the light-emitting connection line covers the light-emitting control line in their overlapping region, and the reset connection line covers the reset control line in their overlapping region. This arrangement reduces or even eliminates the coupling capacitance between the light-emitting control line and the active pattern, as well as between the reset control line and the active pattern.

In some embodiments, as shown in FIGs. 6 to 16, the driving circuit layer 22 includes a first via 301. The light-emitting control line EM penetrates through the first via 301 and is connected to the light-emitting connection line EM-L. The light-emitting control line EM is symmetrically arranged with respect to the first via 301. By having the light-emitting control line penetrate through the first via to connect with the light-emitting connection line, and arranging the light-emitting control line symmetrically with respect to the first via, the light-emitting connection line can effectively shield the light-emitting control line. This prevents the light-emitting control line from being directly opposed to the active pattern, which would form a coupling capacitance. Consequently, the coupling capacitance between the light-emitting control line and the active pattern is reduced, the risk of tip discharge between the light-emitting connection line and the active pattern is lowered, and the yield of the display panel is improved.

Specifically, the light-emitting connection line is symmetrically arranged with respect to the first via.

Specifically, compared with the comparative display device where the connection between the first light-emitting control line and the second light-emitting control line is located on the lower side close to the first light-emitting control line, the embodiments of the present application arrange the light-emitting control line symmetrically with respect to the first via. This configuration can reduce the risk of tip discharge between the light-emitting connection line and the active pattern, thereby improving the yield of the display panel.

Specifically, the first via 301 passes through both the interlayer insulating layer 227 and the second gate insulating layer 225.

In some embodiments, as shown in FIGs. 6 to 16, the driving circuit layer 22 further includes a pixel driving circuit 220, an active layer 222, a first source-drain layer 228, and a second via 302. The pixel driving circuit 220 includes a reset transistor T7. The active layer 222 includes an active pattern T7A of the reset transistor T7. The first source-drain layer 228 further includes a reset signal line VI-A.

The second via 302 is disposed corresponding to both the reset signal line VI-A and the active pattern T7A of the reset transistor T7. The reset signal line VI-A penetrates through the second via 302 and is connected to the active pattern T7A of the reset transistor T7. By configuring the reset signal line in the first source-drain layer and arranging the second via corresponding to both the active pattern of the reset transistor and the reset signal line, the portion of the reset signal line located in the active layer can be eliminated. This avoids occupying space in the active layer and improves the aperture ratio.

Specifically, compared with the comparative display device where the reset signal line is formed in two parts using the semiconductor film layer and the first source-drain film layer, the embodiments of the present application consider the minimal impact of the semiconductor film layer on the impedance of the reset signal line. By removing the portion of the reset signal line located in the active layer, a single-layer design for the reset signal line is adopted, avoiding the use of space in the active layer and preventing yield reduction due to process complexity. By arranging the second via corresponding to both the active pattern of the reset transistor and the reset signal line, the reset signal line can directly penetrate through the second via to connect with the active pattern of the reset transistor, eliminating the need for additional transfer lines, reducing process steps, and minimizing space usage.

Specifically, the second via 302 passes through all of the interlayer insulating layer 227, the second gate insulating layer 225, and the first gate insulating layer 223.

In some embodiments, as shown in FIGs. 6 to 16, the driving circuit layer 22 further includes a pixel driving circuit 220, an active layer 222, a first source-drain layer 228, and a third via 303. The pixel driving circuit 220 includes an initialization transistor T4. The active layer 222 includes an active pattern T4A of the initialization transistor T4. The first source-drain layer 228 further includes an initialization signal line VI-Q.

The third via 303 is disposed corresponding to both the initialization signal line VI-Q and the active pattern T4A of the initialization transistor T4. The initialization signal line VI-Q penetrates through the third via 303 and is connected to the active pattern T4A of the initialization transistor T4. By configuring the initialization signal line in the first source-drain layer and arranging the third via corresponding to both the active pattern of the initialization transistor and the initialization signal line, the portion of the initialization signal line that was previously in the active layer and the second gate layer can be shifted to the first source-drain layer. This reduces impedance and avoids occupying space in the active layer, thereby improving the aperture ratio.

Specifically, compared with the comparative display device where the initialization signal line is formed in two parts using the semiconductor film layer and the second gate film layer, the embodiments of the present application consider the relatively high impedance of the semiconductor film layer and the second gate film layer. By forming the initialization signal line in the first source-drain layer, the impedance of the initialization signal line is reduced. This allows for a single-layer design of the initialization signal line, avoiding the use of space in the active layer and preventing yield reduction due to process complexity. By arranging the third via corresponding to both the active pattern of the initialization transistor and the initialization signal line, the initialization signal line can directly penetrate through the third via to connect with the active pattern of the initialization transistor, eliminating the need for additional transfer lines, reducing process steps, and minimizing space usage.

Specifically, the third via 303 passes through all of the interlayer insulating layer 227, the second gate insulating layer 225, and the first gate insulating layer 223.

Specifically, the impedance of the first source-drain layer is less than both the impedance of the second gate layer and the impedance of the active layer.

In some embodiments, as shown in FIGs. 6 to 16, the driving circuit layer 22 further includes data lines Data. The orthographic projections of the light-emitting connection lines EM-L on the substrate 21 are spaced apart from the orthographic projections of at least part data lines Data on the substrate 21. By ensuring that the orthographic projections of the light-emitting connection lines EM-L on the substrate 21 are spaced apart from the orthographic projections of at least part data lines Data on the substrate 21, the plurality of light-emitting connection lines EM-L can be arranged in a disconnected configuration, and the coupling capacitance between each light-emitting connection line EM-L and the corresponding data line Data is reduced. This decreases the total capacitance of at least part of the data lines, preventing crosstalk caused by insufficient pixel charging time or incorrect charging, thereby improving display uniformity and enhancing display performance.

Specifically, compared with the comparative display device where the first light-emitting control line and the second light-emitting control line each overlap with a data line, the embodiments of the present application achieve a reduction in coupling capacitance by disconnecting the plurality of light-emitting connection lines. The portions of the light-emitting connection lines that serve as the gates of the first and second light-emitting control transistors are retained, ensuring that the orthographic projections of the light-emitting connection lines on the substrate do not overlap with the orthographic projections of at least part data lines on the substrate. This reduces the coupling capacitance between the light-emitting control lines and at least part data lines.

In some embodiments, as shown in FIGs. 6 to 16, the driving circuit layer 22 further includes data lines Data. The orthographic projections of the reset connection lines RL on the substrate 21 are spaced apart from the orthographic projections of at least part data lines Data on the substrate 21. By ensuring that the orthographic projections of the reset connection lines RL on the substrate 21 are spaced apart from the orthographic projections of at least part data lines Data on the substrate 21, the plurality of reset connection lines RL can be arranged in a disconnected configuration, resulting in a smaller coupling capacitance between each reset control line Reset-A and the corresponding data line Data. This reduces the total capacitance of the data lines, preventing crosstalk caused by insufficient pixel charging time or incorrect charging, thereby improving display uniformity and enhancing display performance.

Specifically, compared with the comparative display device where both the first reset control trace and the second reset control trace overlap with the data line, the embodiments of the present application achieve a reduction in coupling capacitance by disconnecting the plurality of reset connection lines. The portions of the reset connection lines that serve as the gates of the reset transistors are retained, ensuring that the orthographic projections of the reset connection lines on the substrate do not overlap with the orthographic projections of the data lines on the substrate. This reduces the coupling capacitance between the reset control lines and at least part data lines.

In some embodiments, as shown in FIGs. 3 to 16, the driving circuit layer 22 further includes a first gate layer 224, a first source-drain layer 228, and a second source-drain layer 232. The second source-drain layer 232 is disposed on a side of the first source-drain layer 228 that is away from the first gate layer 224. The second source-drain layer 232 includes a high-potential power line VDD.

The first gate layer 224 further includes an initialization connection line SL2, and the first source-drain layer further includes an initialization control line Reset-Q. The initialization connection line SL2 includes a first connection portion SL2a and a second connection portion SL2b. The first connection portion SL2a is connected to both the initialization control line Reset-Q and the second connection portion SL2b. The orthographic projection of an end of the first connection portion SL2a on the substrate 21 is spaced apart from the orthographic projection of an end of the high-potential power line VDD on the substrate 21. By ensuring that the orthographic projection of an end of the first connection portion on the substrate is spaced apart from the orthographic projection of an end of the high-potential power line on the substrate, the coupling capacitance between the high-potential power line and the initialization control line can be reduced, thereby improving display uniformity and enhancing display performance.

Specifically, the initialization control line penetrates through a via to connect with an end of the first connection portion SL2a. The orthographic projection of the other end of the first connection portion SL2a on the substrate is spaced apart from the orthographic projection of an end of the high-potential power line VDD on the substrate.

In some embodiments, as shown in FIGs. 3 to 16, the driving circuit layer 22 further includes a first gate layer 224, a second gate layer 226, a first source-drain layer 228, and a second source-drain layer 232. The second gate layer 226 is disposed between the first gate layer 224 and the first source-drain layer 228. The second source-drain layer 232 is disposed on a side of the first source-drain layer 228 that is away from the second gate layer 226. The second gate layer 226 includes a first high-potential power connection line VDD-L1. The first source-drain layer 228 includes a second high-potential power connection line VDD-L2. The second source-drain layer 232 includes a high-potential power line VDD.

The second high-potential power connection line VDD-L2 is connected to both the first high-potential power connection line VDD-L1 and the high-potential power line VDD. The driving circuit layer 22 further includes a fourth via 304. The second high-potential power connection line VDD-L2 penetrates through the fourth via 304 to connect with the first high-potential power connection line VDD-L1. The lower end of the fourth via 304 is aligned with the lower end of the second high-potential power connection line VDD-L2 on the same straight line. By aligning the lower end of the fourth via with the lower end of the second high-potential power connection line on the same straight line, the fourth via is positioned further from the active pattern of the driving transistor. This prevents the fourth via from affecting the electrical properties of the active pattern of the driving transistor, thereby enhancing the electrical stability of the driving transistor.

Specifically, as shown in FIG. 5, the pixel driving circuit 220 includes a switching transistor T2, a driving transistor T1, a compensation transistor T3, and an initialization transistor T4. A gate of the switching transistor T2 is connected to a switch control line Scan(n), a first electrode of the switching transistor T2 is connected to the data line Data, and both a second electrode of the switching transistor T2 and a first electrode of the driving transistor T1 are connected to a first node A. A gate of the compensation transistor T3 is connected to the switch control line Scan(n), both a first electrode of the compensation transistor T3 and a gate of the driving transistor T1 are connected to a second node Q, and both a second electrode of the compensation transistor T3 and a second electrode of the driving transistor T1 are connected to a third node B. A gate of the initialization transistor T4 is connected to the initialization control line Reset-Q, a first electrode of the initialization transistor T4 is connected to the initialization signal line VI-Q, and both a second electrode of the initialization transistor T4 and a gate of the driving transistor T1 are connected to the second node Q.

Specifically, as shown in FIG. 5, the pixel driving circuit 220 further includes a first light-emitting control transistor T5, a second light-emitting control transistor T6, a reset transistor T7, and a storage capacitor Cst.

A gate of the first light-emitting control transistor T5 is connected to the light-emitting control line EM, a first electrode of the first light-emitting control transistor T5 is connected to the high-potential power line VDD, and both a second electrode of the first light-emitting control transistor T5 and a first electrode of the driving transistor T1 are connected to the first node A.

A gate of the second light-emitting control transistor T6 is connected to the light-emitting control line EM, and both a first electrode of the second light-emitting control transistor T6 and a second electrode of the driving transistor T1 are connected to the third node B.

A gate of the reset transistor T7 is connected to the reset control line Reset-A, a first electrode of the reset transistor T7 is connected to the reset signal line VI-A, both a second electrode of the reset transistor T7 and a second electrode of the second light-emitting control transistor T6 are connected to a fourth node C, and both a second electrode of the reset transistor T7 and an anode of the light-emitting device LED are connected to the fourth node C.

An electrode plate of the storage capacitor Cst is connected to the high-potential power line VDD, and both the other electrode plate of the storage capacitor Cst and the gate of the driving transistor T1 are connected to the second node Q.

Specifically, as shown in FIG. 5, the cathode of the light-emitting device LED is connected to a low-potential power line VSS.

Specifically, it can be understood that the display panel includes a plurality of switch control lines, each of which is capable of driving a row of pixel units. The switch control line Scan(n) is the nth switch control line among the plurality of switch control lines, where n is greater than or equal to 1 and is a positive integer. The switch control line Scan(n) may be connected to a gate driver circuit to receive input signals, or it can directly receive input signals through a driver chip. Similarly, the display panel may include a plurality of initialization control lines, a plurality of reset control lines, and a plurality of light-emitting control lines. Each initialization control line, each light-emitting control line, and each reset control line drives a row of pixel units. The initialization control line, the light-emitting control line, and the reset control line may also be connected to the gate driver circuit or receive input signals through a driver chip. The gate driver circuit connected to the initialization control line, the light-emitting control line, and the reset control line may be the same as or different from the gate driver circuit connected to the switch control line.

Specifically, it can be understood that since each via is filled with a structure and the layers are stacked, the positions of the vias are not visible. It can be understood that the positions of the vias can be determined based on the positions of the structures.

In some embodiments, as shown in FIGs. 3 to 16, the display panel 2 includes a plurality of pixel units 240 that are arranged in an array. The pixel unit 240 includes a first sub-pixel unit 240a, a second sub-pixel unit 240b, and a third sub-pixel unit 240c. The first sub-pixel unit 240a includes a first light-emitting device 341. The second sub-pixel unit 240b includes a second light-emitting device 342. The third sub-pixel unit 240c includes a third light-emitting device 343. The area of the anode ANO1 of the first light-emitting device 341, the area of the anode ANO2 of the second light-emitting device 342, and the area of the anode ANO3 of the third light-emitting device 343 are different from each other. Due to the varying luminous efficiencies of different light-emitting devices, by making the areas of the anodes of the first, second, and third light-emitting devices different, the volume of each light-emitting device can be adjusted according to its luminous efficiency. This ensures consistent luminous brightness across the devices, thereby enhancing the display effect.

Specifically, it can be understood that the light-emitting device LED includes the first light-emitting device, the second light-emitting device, and the third light-emitting device. The anode of the light-emitting device LED includes the anode of the first light-emitting device, the anode of the second light-emitting device, and the anode of the third light-emitting device.

Specifically, as shown in FIG. 3 and FIG. 4, the light-emitting material layer 243 includes a first light-emitting material layer 243a, a second light-emitting material layer 243b, and a third light-emitting material layer 243c. The emission color of the first light-emitting material layer 243a, the emission color of the second light-emitting material layer 243b, and the emission color of the third light-emitting material layer 243c are different from each other. Specifically, the pixel electrode layer forms the anode of the light-emitting device, the light-emitting material layer forms the light-emitting material of the device, and the common electrode forms the cathode of the light-emitting device.

Specifically, taking the first light-emitting material layer 243a, the second light-emitting material layer 243b, and the third light-emitting material layer 243c as examples, with their emission colors being red, green, and blue respectively, and considering the different luminous efficiencies of each material-where the blue light-emitting material has the lowest efficiency and the red light-emitting material has the highest efficiency-the area of the anode of the first light-emitting device can be made smaller than the area of the second light-emitting device, and the area of the anode of the second light-emitting device can be smaller than the area of the third light-emitting device.

In some embodiments, as shown in FIGs. 2 to 16, in the first direction X, the width of the anode ANO1 of the first light-emitting device 341 is less than the width of the anode ANO2 of the second light-emitting device 342; the width of the anode ANO2 of the second light-emitting device 342 is less than the width of the anode ANO3 of the third light-emitting device 343. The first direction X is the same as the extension direction of the light-emitting control line. By making the width of the anode of the first light-emitting device less than the width of the anode of the second light-emitting device, and the width of the anode of the second light-emitting device less than the width of the anode of the third light-emitting device, the volume of each light-emitting device can be adjusted according to its luminous efficiency. This ensures consistent luminous brightness across the light-emitting devices, thereby enhancing the display effect.

In some embodiments, as shown in FIGs. 3 to 6 and FIG. 7, the driving circuit layer 22 further includes an active layer 222. The display panel 2 includes a plurality of pixel units 240 that are arranged in an array. Each pixel unit 240 includes three pixel driving circuits 220. In each pixel driving circuit 220, the active layer 222 includes the active pattern T1A of the driving transistor T1, the active pattern T2A of the switching transistor T2, the first electrode T2S of the switching transistor T2, the active pattern T3A of the compensation transistor T3, the first electrode T3S of the compensation transistor T3, the active pattern T4A of the initialization transistor T4, the first electrode T4S of the initialization transistor, the second electrode T4D of the initialization transistor, the active pattern T5A of the first light-emitting control transistor T5, the first electrode T5S of the first light-emitting control transistor T5, the active pattern T6A of the second light-emitting control transistor T6, the second electrode T6D of the second light-emitting control transistor T6, the active pattern T7A of the reset transistor T7, the first electrode T7S of the reset transistor T7, the second electrode T7D of the reset transistor T7, the first node A, and the third node B. The active pattern T1A of the driving transistor T1 is arranged in the first direction X. The active pattern T2A of the switching transistor T2, the active pattern T4A of the first initialization transistor T4, the active pattern T5A of the first light-emitting control transistor T5, the active pattern T6A of the second light-emitting control transistor T6, and the active pattern T7A of the reset transistor T7 are all arranged in the second direction Y. The active pattern T3A of the compensation transistor T3 includes a portion arranged in the first direction X and another portion arranged in the second direction Y. The active pattern T1A of the driving transistor T1 is connected to all of the active pattern T2A of the switching transistor T2, the active pattern T3A of the compensation transistor T3, the active pattern T5A of the first light-emitting control transistor T5, and the active pattern T6A of the second light-emitting control transistor T6. The active pattern T3A of the compensation transistor T3 is connected to the active pattern T4A of the first initialization transistor T4. The active pattern T6A of the second light-emitting control transistor T6 is connected to the active pattern T7A of the reset transistor T7. The angle between the first direction X and the second direction Y is greater than 0 and less than or equal to 90 degrees.

Specifically, FIGs. 6 to 16 intercept the parts in the two rows of pixel units, so it can be seen that the reset transistor is located below the second light-emitting control transistor.

In some embodiments, as shown in FIGs. 3 to 6 and FIG. 8, the driving circuit layer 22 further includes a first gate layer 224. In each pixel driving circuit 220, the first gate layer 224 includes the gate T1G of the driving transistor T1, the gate T2G of the switch transistor T2, the gate T3G of the compensation transistor T3, the gate T4G of the initialization transistor T4, the gate T5G of the first light-emitting control transistor T5, the gate T6G of the second light-emitting control transistor T6, the gate T7G of the reset transistor T7, the first electrode plate Cst1 of the storage capacitor Cst, the light-emitting connection line EM-L, a switch connection line SL1, the initialization connection line SL2, and the reset connection line RL. The initialization connection line SL2, the switch connection line SL1, the gate T1G of the driving transistor T1, the light-emitting connection line EM-L, and the reset connection line RL are sequentially spaced in the second direction Y.

Specifically, as shown in FIG. 6 and FIG. 8, in a row of pixel units, the light-emitting connection lines EM-L are arranged in a disconnected configuration, and the reset connection lines RL are arranged in a disconnected configuration.

Specifically, as shown in FIG. 8, the gate T2G of the switching transistor T2 is connected to the gate T3G of the compensation transistor T3.

Specifically, as shown in FIG. 8, it can be seen that some structures are identified using a plurality of labels. This is because the electrodes and signal lines share this structure, and the signals transmitted on this structure are the same (disregarding the voltage drop). For example, the gate T5G of the first light-emitting control transistor T5 is labeled the same as the light-emitting connection line EM-L. This is because the portion of the light-emitting connection line EM-L corresponding to the active pattern of the first light-emitting control transistor T5 serves as the gate T5G of the first light-emitting control transistor T5. Similarly, the meaning of other structures identified with a plurality of labels can be determined.

Specifically, as shown in FIGs. 6 to 8, it can be understood that the gates of the transistors are arranged corresponding to the active patterns of the respective transistors. For example, the gate T3G of the compensation transistor corresponds to the active pattern T3A of the compensation transistor T3.

In some embodiments, as shown in FIGs. 5 to 8, the gate T3G of the compensation transistor T3 includes a first gate T3Ga and a second gate T3Gb, which are connected to each other. By designing the gate of the compensation transistor with a dual-gate configuration, the gate control capability of the display panel can be enhanced, and leakage current can be reduced.

In some embodiments, as shown in FIGs. 5 to 8, the gate T4G of the initialization transistor T4 includes a third gate T4Ga and a fourth gate T4Gb, which are connected to each other. By designing the gate of the initialization transistor with a dual-gate configuration, the gate control capability of the display panel can be enhanced, and leakage current can be reduced.

In some embodiments, as shown in FIGs. 3 to 6 and FIG. 9, the driving circuit layer 22 further includes a second gate layer 226. In each pixel driving circuit 220, the second gate layer 226 includes a first high-potential power connection line VDD-L1 and a second electrode plate Cst2 of the storage capacitor Cst. The first high-potential power connection line VDD-L1 is connected to the second electrode plate Cst2 of the storage capacitor Cst.

Specifically, as shown in FIG. 6 and FIG. 9, the first high-potential power connection line VDD-L1 is connected to the second electrode plate Cst2 of the storage capacitor Cst. The second electrode plate Cst2 of the storage capacitor Cst is provided with a via. The second electrode plate Cst2 of the storage capacitor Cst is disposed corresponding to the first electrode plate Cst1 of the storage capacitor Cst. The second electrode of the compensation transistor may be connected to the gate of the driving transistor through a via.

Specifically, the second gate layer may also include a repair line. By setting the repair line within the pixel unit, if an anomaly occurs in the sub-pixel unit or pixel unit, the connection between the anode of the light-emitting device corresponding to the sub-pixel unit and the pixel driving circuit can be disconnected. The repair line can be directly connected to the anode of the sub-pixel unit, allowing direct driving of the sub-pixel unit and preventing dark spots. When there is no anomaly in the sub-pixel unit or pixel unit, the repair line can be left floating.

In some embodiments, as shown in FIGs. 3 to 6 and FIG. 10, the driving circuit layer 22 further includes a first source-drain layer 228. In each pixel driving circuit 220, the first source-drain layer 228 includes the initialization signal line VI-Q, the initialization control line Reset-Q, the switch control line Scan(n), the second high-potential power connection line VDD-L2, the light-emitting control line EM, the reset control line Reset-A, the reset signal line VI-A, a first transfer line KL1, a second transfer line KL2, a third transfer line KL3, and a fourth transfer line KL4. The initialization signal line VI-Q, the initialization control line Reset-Q, the switch control line Scan(n), the first transfer line KL1, the second high-potential power connection line VDD-L2, the light-emitting control line EM, the third transfer line KL3, the reset control line Reset-A, and the reset signal line VI-A are sequentially spaced in the second direction Y.

Specifically, as shown in FIGs. 6 to 10, in a row of pixel units, the initialization signal line VI-Q is continuous and is connected to the first electrode T4S of the initialization transistor T4.

Specifically, as shown in FIGs. 6 to 10, in a row of pixel units, the initialization control line Reset-Q is continuous and is connected to the initialization connection line SL2, thereby reducing the impedance of the initialization control line.

Specifically, as shown in FIGs. 6 to 10, in a row of pixel units, the switch control line Scan(n) is connected to the switch connection line SL1.

Specifically, as shown in FIGs. 6 to 10, in a row of pixel units, the second high-potential power connection line VDD-L2 is continuous and is connected to the second electrode plate Cst2 of the storage capacitor Cst. This allows the second high-potential power connection line VDD-L2 to connect with the first high-potential power connection line VDD-L1, reducing the impedance of the high-potential power line.

Specifically, as shown in FIGs. 6 to 10, in a row of pixel units, the light-emitting control line EM is continuous and is connected to the light-emitting connection line EM-L, thereby reducing the impedance of the light-emitting control line.

Specifically, as shown in FIGs. 6 to 10, in a row of pixel units, the reset control line Reset-A is continuous and is connected to the reset connection line RL, thereby reducing the impedance of the reset control line.

Specifically, as shown in FIGs. 6 to 10, in a row of pixel units, the reset signal line VI-Ais continuous and is connected to the first electrode T7S of the reset transistor T7.

Specifically, as shown in FIGs. 6 to 10, the first transfer line KL1 is connected to the first electrode T2S of the switching transistor T2. An end of the second transfer line KL2 is connected to the first electrode T3S of the compensation transistor T3, and the other end of the second transfer line KL2 is connected to the gate T1G of the driving transistor T1. The third transfer line KL3 is connected to the first electrode T5S of the first light-emitting control transistor T5. The fourth transfer line KL4 is connected to the second electrode T6D of the second light-emitting control transistor T6.

In some embodiments, as shown in FIGs. 3 to 6 and FIG. 11, the driving circuit layer 22 further includes a second source-drain layer 232. In each pixel unit 240, the second source-drain layer 232 includes three data lines Data, three high-potential power lines VDD, a low-potential power line VSS, a reset connection line VI-L, and three anode connection lines ANO-L. The three data lines Data and the three high-potential power lines VDD are alternately arranged in the first direction X. The low-potential power line VSS is disposed at a side of the high-potential power line VDD that is away from the data line Data. The reset connection line VI-L is disposed between one of the data lines Data and one of the high-potential power lines VDD. Each of the anode connection lines ANO-L is disposed between one of the high-potential power lines VDD and one of the data lines Data. The three high-potential power lines VDD are connected to one of the second high-potential power connection lines VDD-L2.

Specifically, as shown in FIG. 6 and FIG. 11, the data line Data, the high-potential power line VDD, the low-potential power line VSS, the reset connection line VI-L, and the anode connection line ANO-L are all arranged in the second direction Y.

Specifically, as shown in FIGs. 6 to 11, the data line Data is connected to the first transfer line KL1, and the high-potential power line VDD is connected to both the second high-potential power connection line VDD-L2 and the third transfer line KL3. This configuration enables the meshing and signal transmission of the high-potential power line VDD, reducing its impedance. It can be understood that the signals on the first high-potential power connection line and the second high-potential power connection line are signals of the high-potential power line, and the first high-potential power connection line and the second high-potential power connection line can be considered as part of the high-potential power line.

Specifically, as shown in FIGs. 6 to 11, the anode connection line ANO-L may be connected to the fourth transfer line KL4.

In some embodiments, as shown in FIGs. 3 to 6, FIG. 11, and FIG. 12, the light-emitting functional layer 24 includes a pixel electrode layer 241. In each pixel unit 240, the pixel electrode layer 241 includes the anodes ANO of three light-emitting devices LED. The anode ANO of each light-emitting device LED is connected to one of the anode connection lines ANO-L. Each anode connection line ANO-L is connected to one of the fourth transfer lines.

Specifically, the orthographic projection of the anode of the light-emitting device on the substrate is at least partially overlapped with the orthographic projection of the high-potential power line on the substrate.

Specifically, as shown in FIG. 12, the anode ANO of the light-emitting device LED extends along the second direction Y, and the anodes ANO of the plurality of light-emitting devices LED are spaced in the first direction X. The anode ANO of each light-emitting device LED is connected to the anode connection line ANO-L, which is connected to the fourth transfer line KL4. The fourth transfer line KL4 is connected to the second electrode T6D of the second light-emitting control transistor T6, thereby establishing a connection between the light-emitting device and the second light-emitting control transistor.

In some embodiments, as shown in FIGs. 3 to 12, the display panel 2 includes a plurality of pixel units 240 that are arranged in an array. The pixel unit 240 includes a first sub-pixel unit 240a, a second sub-pixel unit 240b, and a third sub-pixel unit 240c. The first sub-pixel unit 240a includes a first light-emitting device 341. The second sub-pixel unit 240b includes a second light-emitting device 342. The third sub-pixel unit 240c includes a third light-emitting device 343. The pixel driving circuit 220 includes a first pixel driving circuit 220a, a second pixel driving circuit 220b, and a third pixel driving circuit 220c, which are electrically connected to the anode of the first light-emitting device 341, the anode of the second light-emitting device 342, and the anode of the third light-emitting device 343, respectively. The data line Data includes a first data line Data-R, a second data line Data-G, and a third data line Data-B, which are electrically connected to the first pixel driving circuit 220a, the second pixel driving circuit 220b, and the third pixel driving circuit 220c, respectively. The high-potential power line VDD includes a first high-potential power line VDD1, a second high-potential power line VDD2, and a third high-potential power line VDD3, which are electrically connected to the first pixel driving circuit 220a, the second pixel driving circuit 220b, and the third pixel driving circuit 220c, respectively.

Specifically, the first data line Data-R, the second data line Data-G, and the third data line Data-B may correspond to the first sub-pixel unit, the second sub-pixel unit, and the third sub-pixel unit, respectively. It can be understood that, when the display panel displays, the brightness of different sub-pixel units may be the same or different. Therefore, there may be situations where different driving voltages are used to drive different sub-pixel units. In such cases, the first data line Data-R, the second data line Data-G, and the third data line Data-B can input different voltages to allow each sub-pixel unit to display the corresponding brightness.

Specifically, the first high-potential power line VDD1, the second high-potential power line VDD2, and the third high-potential power line VDD3 may correspond to the first sub-pixel unit, the second sub-pixel unit, and the third sub-pixel unit, respectively. The first high-potential power line VDD1, the second high-potential power line VDD2, and the third high-potential power line VDD3 may be the same or different.

Simultaneously, to illustrate the relative positions of each film layer, FIG. 6 and FIGs. 13 to 16 are provided for explanation. FIG. 13 shows the relative positions of the structure of the first gate layer 224 and the structure of the active layer 222.

FIG. 14 shows the relative positions of the structure of the active layer 222, the structure of the first gate layer 224, and the structure of the second gate layer 226. FIG. 15 shows the relative positions of the structure of the active layer 222, the structure of the first gate layer 224, the structure of the second gate layer 226, and the structure of the first source-drain layer 228. FIG. 16 shows the relative positions of the structure of the active layer 222, the structure of the first gate layer 224, the structure of the second gate layer 226, the structure of the first source-drain layer 228, and the structure of the second source-drain layer 232.

Specifically, the first electrode of the transistor in the above embodiments is a source, while the second electrode is a drain. Alternatively, the first electrode of the transistor in the above embodiments is a drain, while the second electrode is a source.

Specifically, the material of the active layer includes silicon-based semiconductor, which may be low-temperature polycrystalline silicon. Alternatively, the material of the active layer includes an oxide semiconductor material, specifically a metal oxide semiconductor material, and more specifically, indium gallium zinc oxide.

Specifically, the driving transistor, the switching transistor, the compensation transistor, the initialization transistor, the first light-emitting control transistor, the second light-emitting control transistor, and the reset transistor may all be P-type transistors or N-type transistors.

Specifically, it can be understood that due to differences in the sections taken when splitting each film layer, some layers may have partial structural omissions. It can be understood that the structures of each film layer in the display panel can be referenced in FIG. 6, and their relative positions and dimensions can be determined in conjunction with other figures. For example, in FIG. 11, the first data line Data-R in the second source-drain layer 232 may have some omissions, and the low-potential power line VSS is not shown. However, it can be understood that the position and dimensions of the first data line Data-R and the low-potential power line VSS can be determined by referring to FIG. 6 and other figures.

Specifically, the aforementioned embodiments provide a detailed description of the display panel from various aspects, including the circuit, film layer structure, specific design of each film layer, and the connections and relative relationships between the layers. It can be understood that when there is no conflict between the embodiments, they can be combined. For example, both the light-emitting control line and the light-emitting connection line extend along the first direction, the orthographic projection of the light-emitting connection line on the substrate is at least partially overlapped with the orthographic projection of the light-emitting control line on the substrate, and the width of the light-emitting connection line in the second direction is greater than or equal to the width of the light-emitting control line in the second direction. Within the overlapping region between the light-emitting connection line and the light-emitting control line, the orthographic projection of the light-emitting control line on the substrate is located within the orthographic projection of the light-emitting connection line on the substrate. Both the reset control line and the reset connection line extend along the first direction, the orthographic projection of the reset connection line on the substrate is at least partially overlapped with the orthographic projection of the reset control line on the substrate, and the width of the reset connection line in the second direction is greater than or equal to the width of the reset control line in the second direction. Within the overlapping region between the reset connection line and the reset control line, the orthographic projection of the reset control line on the substrate is located within the orthographic projection of the reset connection line on the substrate. The angle between the first direction and the second direction is greater than 0 and less than or equal to 90 degrees.

Additionally, some embodiments of the present application provide a display apparatus, which includes the display panel as described in any one of the above embodiments.

Specifically, the display panel includes an organic light-emitting diode display panel.

In the description of the present application, the terms "first" and "second" are used merely for descriptive purposes and should not be construed as indicating or implying relative importance, nor as implicitly specifying the quantity of the technical features indicated. Thus, features defined as "first" or "second" may explicitly or implicitly include one or more features. In the description of the present application, the term "a plurality of" means two or more than two, unless otherwise specified.

In the above-mentioned embodiments, the description of each embodiment has its own emphasis, and the parts not described in detail in a certain embodiment may be referred to the related description of other embodiments.

The embodiments, implementations, and related technical features of the present application can be combined and replaced with each other without conflict.

The above are merely preferred embodiments of the present application, and do not limit the present application in any form. Any simple modifications, equivalent changes, and modifications made to the above embodiments according to the technical essence of the present application without departing from the contents of the technical solutions of the present application still fall within the scope of the technical solutions of the present application.

## Claims

1. A display panel (2), **characterized in that** the display panel (2) comprises:
a substrate (21); and
a driving circuit layer (22) disposed on a side of the substrate (21), wherein the driving circuit layer (22) comprises a plurality of light-emitting control lines (EM), a plurality of reset control lines (Reset-A), a plurality of light-emitting transfer lines (SL4), and a plurality of reset transfer lines (SL3), one of the plurality of light-emitting transfer lines (SL4) is connected to one of the plurality of light-emitting control lines (EM), and one of the plurality of reset transfer lines (SL3) is connected to one of the plurality of reset control lines (Reset-A);
wherein at least one of the plurality of light-emitting transfer lines (SL4) is provided with a break (311), and/or at least one of the plurality of reset transfer lines (SL3) is provided with a break (311).

2. The display panel (2) according to claim 1, **characterized in that** the display panel (2) further comprises a plurality of pixel units (240), wherein each of the plurality of pixel units (240) comprises a plurality of sub-pixel units;
wherein one of the plurality of light-emitting transfer lines (SL4) is provided with the break (311), the one of the plurality of light-emitting transfer lines (SL4) comprises a plurality of light-emitting connection lines (EM-L), the break (311) is provided between two adjacent ones of the plurality of light-emitting connection lines (EM-L), and each of the plurality of light-emitting connection lines (EM-L) is disposed corresponding to one of the plurality of sub-pixel units.

3. The display panel (2) according to claim 1, **characterized in that** the display panel (2) further comprises a plurality of pixel units (240), wherein each of the plurality of pixel units (240) comprises a plurality of sub-pixel units;
wherein one of the plurality of reset transfer lines (SL3) is provided with the break (311), the one of the plurality of reset transfer lines (SL3) comprises a plurality of reset connection lines (RL), the break (311) is provided between two adjacent ones of the plurality of reset connection lines (RL), and each of the plurality of reset connection lines (RL) is disposed corresponding to one of the plurality of sub-pixel units.

4. The display panel (2) according to claim 1, **characterized in that** the display panel (2) further comprises a plurality of pixel units (240), wherein each of the plurality of pixel units (240) comprises a plurality of sub-pixel units;
wherein one of the plurality of light-emitting transfer lines (SL4) is provided with a first break, the one of the plurality of light-emitting transfer lines (SL4) comprises a plurality of light-emitting connection lines (EM-L), the first break is provided between two adjacent ones of the plurality of light-emitting connection lines (EM-L), and each of the plurality of light-emitting connection lines (EM-L) is disposed corresponding to one of the plurality of sub-pixel units; and
wherein one of the plurality of reset transfer lines (SL3) is provided with a second break, the one of the plurality of reset transfer lines (SL3) comprises a plurality of reset connection lines (RL), the second break is provided between two adjacent ones of the plurality of reset connection lines (RL), and each of the plurality of reset connection lines (RL) is disposed corresponding to one of the plurality of sub-pixel units.

5. The display panel (2) according to claim 2 or claim 4, **characterized in that** the plurality of light-emitting control lines (EM) and the plurality of light-emitting connection lines (EM-L) extend along a first direction (X), an orthographic projection of one of the plurality of light-emitting connection lines (EM-L) on the substrate (21) is at least partially overlapped with an orthographic projection of one of the plurality of light-emitting control lines (EM) on the substrate (21), and a width of the one of the plurality of light-emitting connection lines (EM-L) in a second direction (Y) is greater than or equal to a width of the one of the plurality of light-emitting control lines (EM) in the second direction (Y); and
wherein within an overlapping region between the one of the plurality of light-emitting connection lines (EM-L) and the one of the plurality of light-emitting control lines (EM), the orthographic projection of the one of the plurality of light-emitting control lines (EM) on the substrate (21) is located within the orthographic projection of the one of the plurality of light-emitting connection lines (EM-L) on the substrate (21), and an angle between the first direction (X) and the second direction (Y) is greater than 0 and less than or equal to 90 degrees.

6. The display panel (2) according to claim 3 or claim 4, **characterized in that** the plurality of reset control lines (Reset-A) and the plurality of reset connection lines (RL) extend along a first direction (X), an orthographic projection of one of the plurality of reset connection lines (RL) on the substrate (21) is at least partially overlapped with an orthographic projection of one of the plurality of reset control lines (Reset-A) on the substrate (21), and a width of the one of the plurality of reset connection lines (RL) in a second direction (Y) is greater than or equal to a width of the one of the plurality of reset control lines (Reset-A) in the second direction (Y); and
wherein within an overlapping region between the one of the plurality of reset connection lines (RL) and the one of the plurality of reset control lines (Reset-A), the orthographic projection of the one of the plurality of reset control lines (Reset-A) on the substrate (21) is located within the orthographic projection of the one of the plurality of reset connection lines (RL) on the substrate (21), and an angle between the first direction (X) and the second direction (Y) is greater than 0 and less than or equal to 90 degrees.

7. The display panel (2) according to any one of claims 1 to 6, **characterized in that** the plurality of light-emitting control lines (EM) are disposed in a layer different from the plurality of light-emitting transfer lines (SL4), and the plurality of reset control lines (Reset-A) are disposed in a layer different from the plurality of reset transfer lines (SL3).

8. The display panel (2) according to claim 1, **characterized in that** one of the plurality of light-emitting transfer lines (SL4) comprises a plurality of light-emitting connection lines (EM-L) connected to one of the plurality of light-emitting control lines (EM), and one of the plurality of reset transfer lines (SL3) comprises a plurality of reset connection lines (RL) connected to one of the plurality of reset control lines (Reset-A);
wherein the driving circuit layer (22) comprises a first gate layer (224) and a first source-drain layer (228), wherein the first gate layer (224) is disposed between the substrate (21) and the first source-drain layer (228), the first source-drain layer (228) comprises the plurality of light-emitting control lines (EM) and the plurality of reset control lines (Reset-A), and the first gate layer (224) comprises the plurality of light-emitting connection lines (EM-L) and the plurality of reset connection lines (RL); and
wherein the display panel (2) comprises a plurality of pixel units (240), each of the plurality of pixel units (240) comprises a plurality of sub-pixel units, wherein within two adjacent ones of the plurality of sub-pixel units, two adjacent ones of the plurality of light-emitting connection lines (EM-L) are arranged in a disconnected configuration, and/or two adjacent ones of the plurality of reset connection lines (RL) are arranged in a disconnected configuration.

9. The display panel (2) according to any one of claims 4 to 8, **characterized in that** the driving circuit layer (22) comprises a first gate layer (224) and a first source-drain layer (228), the first gate layer (224) is disposed between the substrate (21) and the first source-drain layer (228), the first gate layer (224) comprises the plurality of light-emitting connection lines (EM-L) and the plurality of reset connection lines (RL), and the first source-drain layer (228) comprises the plurality of light-emitting control lines (EM) and the plurality of reset control lines (Reset-A).

10. The display panel (2) according to any one of claims 4 to 8, **characterized in that** the driving circuit layer (22) is provided with a first via (301), one of the plurality of light-emitting control lines (EM) passes through the first via (301) and is connected to one of the plurality of light-emitting connection lines (EM-L), and the one of the plurality of light-emitting control lines (EM) is symmetrically arranged with respect to the first via (301).

11. The display panel (2) according to any one of claims 1 to 10, **characterized in that** the driving circuit layer (22) further comprises a pixel driving circuit (220), an active layer (222), a first source-drain layer (228), and a second via (302), the pixel driving circuit (220) comprises a reset transistor (T7), the active layer (222) comprises an active pattern (T7A) of the reset transistor (T7), and the first source-drain layer (228) comprises a reset signal line (VI-A); and
wherein the second via (302) is disposed corresponding to both the reset signal line (VI-A) and the active pattern (T7A) of the reset transistor (T7), and the reset signal line (VI-A) passes through the second via (302) and is connected to the active pattern (T7A) of the reset transistor (T7).

12. The display panel (2) according to any one of claims 1 to 10, **characterized in that** the driving circuit layer (22) further comprises a pixel driving circuit (220), an active layer (222), a first source-drain layer (228), and a third via (303), the pixel driving circuit (220) comprises an initialization transistor (T4), the active layer (222) comprises an active pattern (T4A) of the initialization transistor (T4), and the first source-drain layer (228) comprises an initialization signal line (VI-Q); and
wherein the third via (303) is disposed corresponding to both the initialization signal line (VI-Q) and the active pattern (T4A) of the initialization transistor (T4), and the initialization signal line (VI-Q) passes through the third via (303) and is connected to the active pattern (T4A) of the initialization transistor (T4).

13. The display panel (2) according to any one of claims 1 to 10, **characterized in that** the driving circuit layer (22) further comprises a first gate layer (224), a first source-drain layer (228), and a second source-drain layer (232), the second source-drain layer (232) is disposed on a side of the first source-drain layer (228) away from the first gate layer (224), and the second source-drain layer (232) comprises a high-potential power line (VDD); and
wherein the first gate layer (224) comprises an initialization connection line (SL2), and the first source-drain layer (228) comprises an initialization control line (Reset-Q); the initialization connection line (SL2) comprises a first connection portion (SL2a) and a second connection portion (SL2b), the first connection portion (SL2a) is connected to both the initialization control line (Reset-Q) and the second connection portion (SL2b), and an orthographic projection of an end of the first connection portion (SL2a) on the substrate (21) is spaced apart from an orthographic projection of an end of the high-potential power line (VDD) on the substrate (21).

14. The display panel (2) according to any one of claims 1 to 10, **characterized in that** the driving circuit layer (22) further comprises a first gate layer (224), a second gate layer (226), a first source-drain layer (228), and a second source-drain layer (232), the second gate layer (226) is disposed between the first gate layer (224) and the first source-drain layer (228), the second source-drain layer (232) is disposed on a side of the first source-drain layer (228) away from the second gate layer (226), the second gate layer (226) comprises a first high-potential power connection line (VDD-L1), the first source-drain layer (228) comprises a second high-potential power connection line (VDD-L2), and the second source-drain layer (232) comprises a high-potential power line (VDD); and
wherein the second high-potential power connection line (VDD-L2) is connected to both the first high-potential power connection line (VDD-L1) and the high-potential power line (VDD), wherein the driving circuit layer (22) further comprises a fourth via (304), the second high-potential power connection line (VDD-L2) penetrates through the fourth via (304) and is connected to the first high-potential power connection line (VDD-L1), and a lower end of the fourth via (304) is aligned with a lower end of the second high-potential power connection line (VDD-L2) on a same straight line.

15. A display apparatus, **characterized in that** the display apparatus comprises the display panel (2) as claimed in any one of claims 1 to 14.
